# EUROPEAN PATENT APPLICATION

(11) **EP 4 528 740 A1**
(43) Date of publication of application: **26.03.2025**
(21) Application number: 24198583.7
(22) Date of filing: 05.09.2024
(51) Int. Cl.: G11C 27/02, H10D 89/10

(54) **SAMPLE AND HOLD CIRCUIT, INTEGRATED CIRCUIT AND METHOD OF MANUFACTURING THE SAME**

(30) Priority: 19.09.2023 KR 20230125002
(71) Applicant: Samsung Electronics Co., Ltd., Gyeonggi-do, 16677 (KR)
(72) Inventor: ROH, Hyungdong, 16677 Suwon-si (KR); LEE, Kyunghoon, 16677 Suwon-si (KR); LIM, Woongtaek, 16677 Suwon-si (KR); CHO, Youngjae, 16677 Suwon-si (KR); CHOI, Michael, 16677 Suwon-si (KR)
(74) Representative: Marks & Clerk LLP

(57) **Abstract**

A sample and hold circuit may include: a first transistor connected between a first input terminal configured to receive a first input signal and a first output terminal configured to output a first sampled signal; a second transistor connected between a second input terminal configured to receive a second input signal and a second output terminal configured to output a second sampled signal; a first dummy transistor provided between the first input terminal and the second output terminal; and a second dummy transistor provided between the second input terminal and the first output terminal. A source region and a drain region of the first dummy transistor and a source region and a drain region of the second dummy transistor may not be electrically connected to a metal line connecting the first transistor with the second transistor.

## Description

### BACKGROUND

The disclosure relates to a sample and hold circuit, an integrated circuit, and a method of manufacturing the same.

A track and hold circuit is one of the basic circuits for use in the front-end of analog-to-digital (A/D) converters and performs a function of sampling values of signals that change continuously over time at a discrete time interval.

Track and hold circuits may consist only of switches and capacitors, so channel charge injection and channel conductance change significantly. These two elements tend to depend mainly on a gate-to-source voltage of each of the switches constituting the track and hold circuit and a threshold voltage of each switch.

### SUMMARY

One or more example embodiments of the disclosure provide a layout arrangement structure of a circuit that may improve the performance of an input end of a sample and hold circuit in a high-speed input.

According to an aspect of an example embodiment, a sample and hold circuit may include: a first transistor connected between a first input terminal configured to receive a first input signal and a first output terminal configured to output a first sampled signal; a second transistor connected between a second input terminal configured to receive a second input signal and a second output terminal configured to output a second sampled signal; a first dummy transistor provided between the first input terminal and the second output terminal; and a second dummy transistor provided between the second input terminal and the first output terminal. A source region and a drain region of the first dummy transistor and a source region and a drain region of the second dummy transistor may not be electrically connected to a metal line connecting the first transistor with the second transistor.

According to an aspect, there is provided a sample and hold circuit comprising: a first transistor connected between a first input terminal configured to receive a first input signal and a first output terminal configured to output a first sampled signal; a second transistor connected between a second input terminal configured to receive a second input signal and a second output terminal configured to output a second sampled signal; a first dummy transistor provided between the first input terminal and the second output terminal; and a second dummy transistor provided between the second input terminal and the first output terminal, wherein a source region and a drain region of the first dummy transistor and a source region and a drain region of the second dummy transistor are not electrically connected to one or more metal lines to which the first transistor and the second transistor are connected. The one or more metal lines may be formed as part of the back end of line (BEOL) process for an integrated circuit to which the sample and hold circuit belongs.

In some embodiments, the first input signal and the second input signal may be equal in magnitude, but of opposite polarity.

In some embodiments, each of the first input signal and the second input signal is a high-frequency analog signal. For example, each of the first input signal and the second input signal may be of a frequency of 1 GHz or higher.

In some embodiments, the sample and hold circuit may further comprise a first capacitor and a second capacitor. A first terminal of the first capacitor may be connected to a drain terminal of the first transistor and to the first output terminal. A second terminal of the first capacitor may be connected to ground. A first terminal of the second capacitor may be connected to a drain terminal of the second transistor and to the second output terminal. A second terminal of the second capacitor may be connected to ground.

According to an aspect of the disclosure, a method of manufacturing an integrated circuit including a metal layer, the method may include: providing a plurality of standard cells each including metal patterns in the metal layer; providing a plurality of dummy transistor region cells adjacent to each other and having the metal patterns of the plurality of standard cells; and removing via connections in the plurality of dummy transistor region cells.

In some embodiments, providing the plurality of standard cells comprises providing a plurality of transistor region cells corresponding to a sample and hold circuit, each of the plurality of transistor region cells comprising a plurality of transistors.

In some embodiments, the method comprises providing a gate of a dummy transistor in each of the plurality of dummy transistor region cells connected to a signal line and providing a gate of a transistor in each of the plurality of transistor region cells connected to the signal line.

According to an aspect of an example embodiment, an integrated circuit may include: a transistor region cell including a pattern corresponding to a plurality of transistors in a sample and hold circuit; and a dummy transistor region cell including the pattern of the transistor region cell. The dummy transistor region cell and the transistor region cell may be connected by metal lines provided in a same layer, and dummy transistors in the dummy transistor region cell may not be connected to the metal lines.

At least some of the above and other features of the invention are set out in the claims.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a block diagram illustrating an analog-to-digital converter according to one or more embodiments;
FIG. 2 is a circuit diagram illustrating a sample and hold circuit according to one or more embodiments;
FIG. 3 is a circuit diagram illustrating a sample and hold circuit according to one or more embodiments;
FIG. 4 illustrates an equivalent circuit of a sample and hold circuit according to one or more embodiments;
FIG. 5 is a diagram illustrating a connection structure of a dummy transistor of FIG. 4;
FIG. 6 is a cross-sectional view illustrating a connection structure of the dummy transistor of FIG. 4;
FIG. 7 is a diagram illustrating layout arrangement of transistors included in a sample and hold circuit according to one or more embodiments;
FIG. 8 is a cross-sectional view of the layout diagram of FIG. 7 taken along line A-A';
FIG. 9 is a flowchart diagram illustrating a method of manufacturing an integrated circuit, according to one or more embodiments;
FIG. 10 is a flowchart illustrating a method of manufacturing an integrated circuit, according to one or more embodiments; and
FIG. 11 is a block diagram illustrating a computing system for designing an integrated circuit according to one or more embodiments.

### DETAILED DESCRIPTION

As the disclosure allows for various changes and numerous embodiments, particular embodiments will be illustrated in the drawings and described in detail. However, this is not intended to limit the disclosure to particular modes of practice, and it is to be appreciated that all changes, equivalents, and substitutes that do not depart from the technical scope of the disclosure are encompassed in the disclosure.

In describing embodiments, detailed descriptions of the related art will be omitted when it is deemed that they may unnecessarily obscure the gist of the disclosure. In addition, ordinal numerals (e.g., 'first', 'second', and the like) used in the description of one or more embodiments are identifier codes for distinguishing one component from another.

Expressions, "at least one of A and B" and "at least one of A or B" and "at least one of A or B" should be interpreted to mean any one of "A" or" B" or "A and B." As another example, "performing at least one of steps 1 and 2" or "performing at least one of steps 1 or 2" means the following three juxtaposition situations: (1) performing step 1; (2) performing step 2; (3) performing steps 1 and 2.

Also, in the disclosure, it should be understood that when components are "connected" or "coupled" to each other, the components may be directly connected or coupled to each other, but may alternatively be connected or coupled to each other with a component therebetween, unless specified otherwise.

As used herein, a component expressed as, for example, `...er (or)', `... unit', `... module', or the like, may denote a unit in which two or more components are combined into one component or one component is divided into two or more components according to its function. In addition, each component to be described below may additionally perform, in addition to its primary function, some or all of functions of other components take charge of, and some functions among primary functions of the respective components may be exclusively performed by other components.

Elements described as "modules" or "part" may be physically implemented by analog and/or digital circuits including one or more of a logic gate, an integrated circuit, a microprocessor, a microcontroller, a memory circuit, a passive electronic component, an active electronic component, and the like.

Hereinafter, various example embodiments of the disclosure are described with reference to the accompanying drawings.

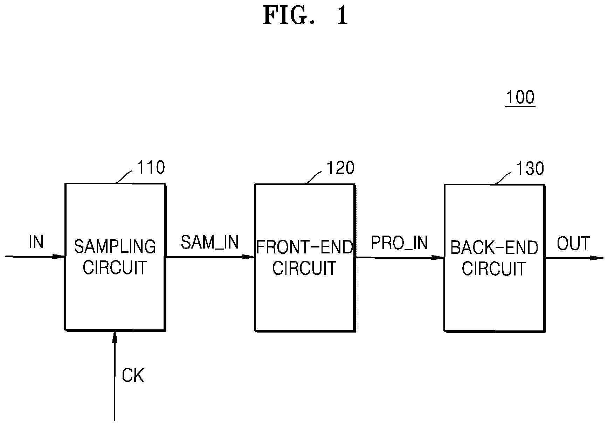

FIG. 1 is a block diagram illustrating an analog-to-digital converter according to one or more embodiments. Referring to FIG. 1, an analog-to-digital converter (ADC) 100 may include a sampling circuit 110, a front-end circuit 120, and a back-end circuit 130.

The sampling circuit 110 may receive an input signal IN, which is an analog signal, and output a sampled signal SAM_IN at predetermined time intervals. In addition, the sampling circuit 110 may provide the sampled signal SAM_IN to the front-end circuit 120. According to one or more embodiments, the sampling circuit 110 may be a sample and hold circuit or a track and hold circuit. In the present specification, the sampling circuit, the sample and hold circuit, and the track and hold circuit may be described interchangeably.

According to one or more examples, a clock signal CK may be supplied to the sampling circuit 110, and the input signal IN may be sampled at rising edges of the clock signal CK. An interval between adjacent rising edges, i.e., time t, may be a sampling period of the sampling circuit 110, and a sampling frequency may be 1/t. In some embodiments, the input signal IN may be sampled at falling edges of the clock signal CK.

The front-end circuit 120 may receive the sampled signal SAM_IN, and process the sampled signal SAM_IN to output the processed signal PRO_IN. Here, the front-end circuit 120 may include circuits for processing the sampled signal SAM_IN, such as an amplifier, a filter, or a mixer. In addition, the front-end circuit 120 may provide the processed signal PRO_IN to the back-end circuit 130.

The back-end circuit 130 may receive the processed signal PRO_IN and may output an output signal OUT FIX, which is a digital signal, by converting the processed signal PRO_IN.

According to one or more examples, the sampling circuit 110 may be included in the ADC 100 as in the example of FIG. 1, or may not be included in the ADC 100, but may be located at the front-end of the ADC 100. Alternatively, the sampling circuit 110 may be provided in a receiver or the like in a communication device.

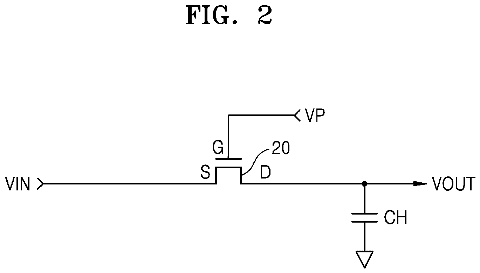

FIG. 2 is a circuit diagram illustrating a sample and hold circuit according to one or more embodiments. In FIG. 2, a pulse signal VP having a certain period is applied to a gate G of a switch composed of an NMOS transistor 20, an analog input signal VIN is applied to a source S thereof, and a hold capacitor CH for maintaining a voltage is coupled to a drain D thereof.

The operation of the sample and hold circuit may be divided into a track mode and a hold mode. In the track mode, when a pulse signal VP in a logic high state is applied, the NMOS transistor 20 may be turned on and the hold capacitor CH may be charged. In the hold mode, when the pulse signal VP is in a logic low state, the NMOS transistor 20 is turned off, and the hold capacitor CH may maintain the charged charge.

A parasitic capacitance exists between the source and drain of the NMOS transistor 20, and when the input signal is a high-frequency signal, the impedance of the parasitic capacitance decreases. When the NMOS transistor 20 changes from the on state to the off state during the hold, the charge accumulated in the channel under the gate of the NMOS transistor 20 is discharged through parasitic capacitance. About 50 % of the discharged charge is transferred to the hold capacitor CH so that the held voltage is changed. That is, a charge corresponding to ((Cox×W×L)/2)×(Vgs-Vth) is transferred to the hold capacitor CH. Here, Cox represents capacitance per unit area of a gate oxide film of the NMOS transistor 20, W represents the gate width, and L represents the gate length. Vgs represents a gate-source voltage, and Vth represents a threshold voltage of the MOS transistor 20. A sample and hold circuit is required to improve a phenomenon in which charges discharged in the off state are transmitted to a hold capacitor.

To improve this, a sample and hold circuit using cross-coupled switches is provided. However, when using dummy transistors (in addition to the parasitic capacitance between the drain region and the source region), the parasitic capacitance between the drain region and the body region and the parasitic capacitance between the source region and the body region take place together. This can limit the operating speed. In addition, there is a problem that resistance components between differential inputs are generated by a second switch and a third switch in the off state.

The sample and hold circuit according to one or more embodiments may reduce unnecessary parasitic capacitance generated by dummy transistors. Hereinafter, the configuration of the sample and hold circuit according to one or more embodiments of the disclosure will be described in more detail.

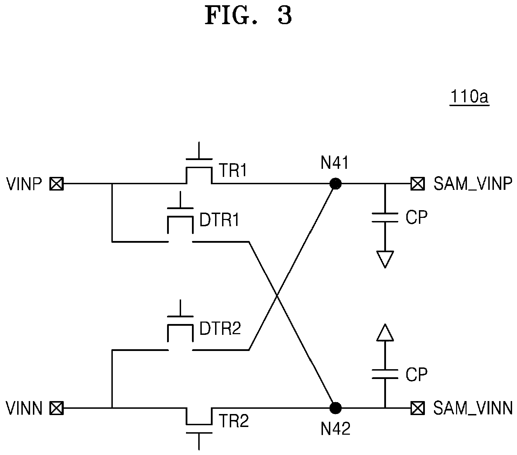

FIG. 3 is a circuit diagram illustrating a sample and hold circuit according to one or more embodiments.

A sampling circuit 110a according to one or more embodiments may receive input signals VINP and VINN, which are a differential signal pair, as input values, and output sampled signals SAM_VINP and SAM_VINN as output values. The sampling circuit 110a according to one or more embodiments may correspond to the sampling circuit 110 of FIG. 1. According to one or more embodiments, the input signals VINP and VINN may be high-speed analog signals. According to one or more embodiments, the input signals VINP and VINN may be analog signals having a speed greater than or equal to gigahertz (GHz) (e.g. greater than or equal to 1 gigahertz (GHz)). The sampling circuit 110a according to one or more embodiments may be a sample and hold circuit capable of sampling high-speed analog signals.

The sampling circuit 110a may include a first transistor TR1, a second transistor TR2, a first dummy transistor DTR1, a second dummy transistor DTR2, and a plurality of capacitors CP. The first transistor TR1 may be connected between a VINP terminal receiving a first input signal and a first node N41. The second transistor TR2 may be connected between a VINN terminal receiving a second input signal and a second node N42. Each of the plurality of capacitors CP may be connected between the first node N41 and a SAM_VINP terminal outputting a first sampled signal, or between the second node N42 and a SAM_VINN terminal outputting a second sampled signal. According to one or more embodiments, the first transistor TR1 and the second transistor TR2 may be NMOS transistors. The VINP terminal receiving the first input signal may be a first input terminal, and the SAM_VINP terminal outputting the first sampled signal may be a first output terminal. The VINN terminal through which the second input signal is received may be a second input terminal, and the SAM_VINN terminal through which the second sampled signal is output may be a second output terminal.

The first dummy transistor DTR1 may be arranged between the terminal VINP receiving the first input signal and the second node N42. The second dummy transistor DTR2 may be arranged between the terminal VINN receiving the second input signal and the first node N41. Referring to FIG. 3, it may be seen that both ends of each of the first dummy transistor DTR1 and the second dummy transistor DTR2 are not connected to the sampling circuit 110a. In one or more embodiments, the meaning of the transistors illustrated not connected to the sampling circuit 110a may mean that the transistors are placed on the layout of the sampling circuit but are not electrically connected to the sampling circuit 110a.

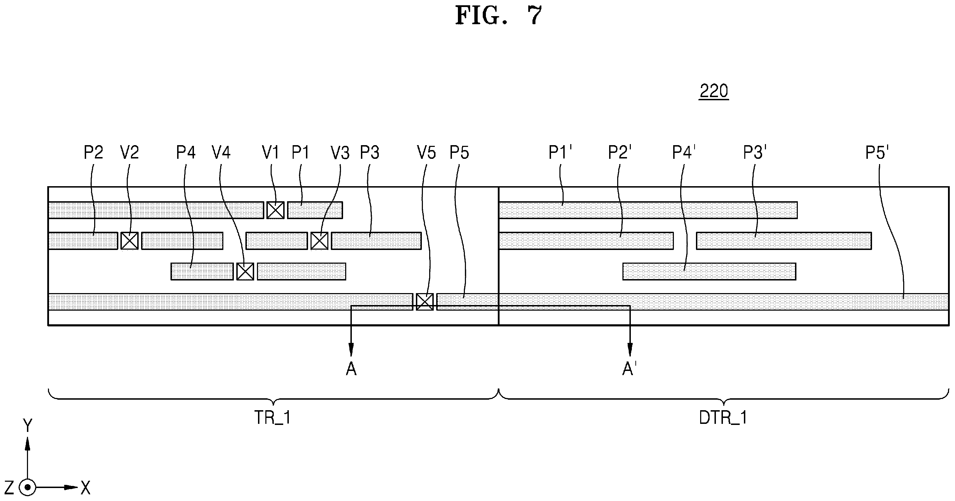

According to one or more embodiments, the first dummy transistor DTR1 and the second dummy transistor DTR2 of the sampling circuit 110a may not be electrically connected to a metal line included in the sampling circuit 110a. The first dummy transistor DTR1 and the second dummy transistor DTR2 according to one or more embodiments may be included in the layout in the sampling circuit 110a, but may not be electrically connected to the sampling circuit 1 10a. According to one or more embodiments, the metal line included in the sampling circuit 110a may mean any one of a plurality of metal lines included in the first metal layer arranged in a back-end of line (BEOL) region capable of electrically connecting the first transistor TR1 and the second transistor TR2 included in the sampling circuit 110a with each other. This will be described in detail later with reference to FIG. 7.

The first dummy transistor DTR1 according to one or more embodiments may be a transistor having the same size as the second transistor TR2. The second dummy transistor DTR2 according to one or more embodiments may be a transistor having the same size as the first transistor TR1. According to one or more embodiments, the signal lines connected to the gate of the first dummy transistor DTR1 and the gate of the second dummy transistor DTR2 may be the same as the signal lines connected to the gate of the first transistor TR1 and the gate of the second transistor TR2, respectively. In other words, the first dummy transistor DTR1 and the first transistor TR1 are connected to a first signal line, and the second dummy transistor DTR2 and the second transistor TR2 are connected to a second signal line. According to one or more embodiments, when an inverter is connected to each of the gate of the first transistor TR1 and the gate of the second transistor TR2, the same inverter may be connected to each of the gate of the first dummy transistor DTR1 and the gate of the second dummy transistor DTR.

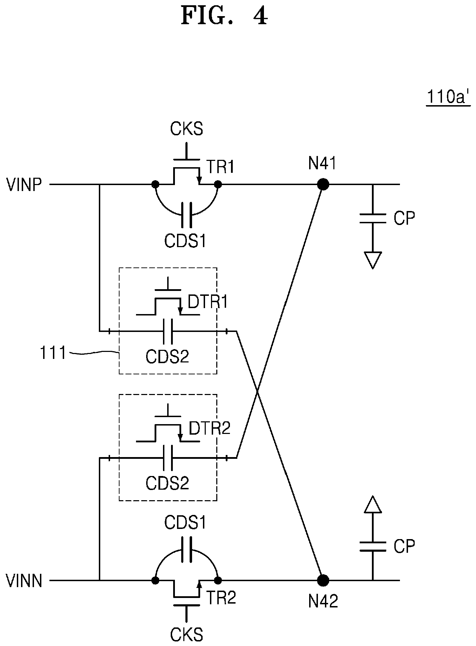

According to one or more embodiments, the first dummy transistor DTR1 and the second dummy transistor DTR2, which have the same sizes as the first transistor TR1 and the second transistor TR2, but are not electrically connected to the sampling circuit 110a may be arranged in the sampling circuit 1 10a. It may be possible to minimize parasitic capacitance between a drain and a body and between a source and a body that may occur when using a transistor by using the same layout pattern as the first transistor TR1 and the second transistor TR2, but implement dummy transistors so as not to be electrically connected to a sampling circuit. The connection structures of the dummy transistors will be described in more detail with reference to FIGS. 4 to 6.

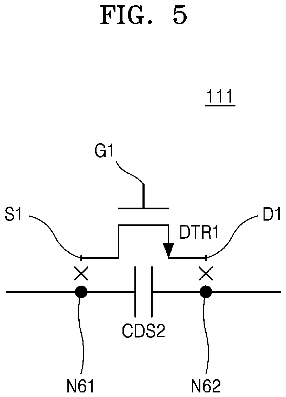

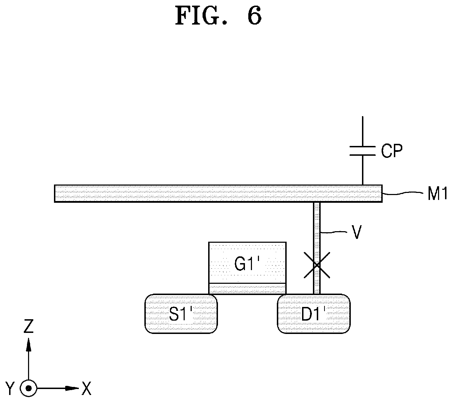

FIG. 4 illustrates an equivalent circuit of a sample and hold circuit according to one or more embodiments. FIG. 5 is a diagram illustrating a connection structure of a dummy transistor of FIG. 4. FIG. 6 is a cross-sectional view illustrating a connection structure of the dummy transistor of FIG. 4.

FIG. 4 is a diagram illustrating an equivalent circuit corresponding to the sampling circuit 110a of FIG. 3 According to one or more embodiments, a sampling circuit 110a' of FIG. 4 may implement a cross-coupled source-to-drain capacitor.

Referring to the equivalent circuit of the sampling circuit 110a' of FIG. 4, a clock signal CKS may be applied to the first transistor TR1 connected between the VINP terminal receiving the first input signal and the first node N41. The clock signal CKS may be applied to the second transistor TR2 connected between the terminal VINN receiving the second input signal and the second node N42.

Referring to FIG. 4, parasitic capacitance generated by each of the first transistor TR1 and the second transistor TR2 may be CDS1. Capacitance generated by each of the first dummy transistor DTR1 and the second dummy transistor DTR2 may be CDS2. According to one or more embodiments, a high-frequency signal may be offset through a structure in which CDS2 having a value corresponding to CDS1, which is a capacitance generated by the first transistor TR1 and the second transistor TR2, is connected in a cross-coupled form.

According to one or more embodiments, the parasitic capacitance CDS2 generated by each of the first dummy transistor TR1 and the second dummy transistor TR2 reflects only capacitance between the source and drain regions of each of the first dummy transistor TR1 and the second dummy transistor TR2 through a configuration that is not connected to the metal line of the sampling circuit 110a', and capacitance by the body-to-drain or the body-to-source may be minimized, and thus, a high frequency signal may be offset compared to a comparative example.

FIG. 5 is a diagram illustrating a region 111 in which the first dummy transistor DTR1 is arranged in the equivalent circuit of FIG. 4. Referring to FIG. 5, the first dummy transistor DTR1 may include a gate terminal G1, a source terminal S1, and a drain terminal D1. The source terminal S1 and the drain terminal D1 of the first dummy transistor DTR1 may not be connected to the metal line in the sampling circuit 110a' of FIG. 4. Referring to FIG. 5, nodes N61 and N62 located at both ends of the parasitic capacitance CDS2 generated by the first dummy transistor DTR1 may not be electrically connected to the first dummy transistor DTR1.

The sample and hold circuit according to the comparative example is configured to include: a transistor connected to a capacitor; and a dummy transistor switch. However, the sample and hold circuit according to one or more embodiments of the disclosure may be configured to include: a transistor connected to a capacitor and a metal dummy pattern corresponding to the transistor.

Referring to FIG. 6, a cross-sectional view of the first dummy transistor DTR1 according to FIG. 5 is illustrated. The first dummy transistor DTR1 may include a source region S1' corresponding to the source terminal, a drain region D1' corresponding to the drain terminal, and a gate region G1' corresponding to the gate terminal. According to one or more embodiments, a via V may be required to electrically connect the drain region D1' with the metal line M1. However, in the case of the first dummy transistor DTR1 according to one or more embodiments, only metal lines may be placed in a BEOL region by removing the via V between the drain region D1' and the metal line M1, and a dummy transistor may be arranged in a front-end of line (FEOL) region.

In terms of the sampling circuit 110a', the first dummy transistor DTR1 according to one or more embodiments may be provided only as a dummy metal line. More specifically, only the metal lines M1 exists in the first dummy transistor DTR1 and the second dummy transistor DTR2 in the BEOL region of the sampling circuit 110a', and the first dummy transistor DTR1 and the second dummy transistor DTR2 may be arranged in the FEOL region.

A technical feature according to one or more embodiments may be an input transistor, that is, a capacitor by a dummy metal line implemented in the same pattern as the first transistor and the second transistor. According to one or more embodiments, a feed-through impact may be reduced by a drain-to-source capacitor of an input transistor of the sample and hold circuit. The sample and hold circuit according to one or more embodiments minimizes parasitic capacitance compared to dummy transistors through the same BEOL pattern as the input transistor, and may minimize the impact of feed-through by applying, to the gate pattern, the same clock signal as the clock signal applied to the input transistor.

In the sample and hold circuit according to the comparative example, when the input switch, that is, a first transistor, is in an off state, the sampled signal should maintain a hold state, but the high frequency signal is transferred to the capacitor due to the influence of the parasitic capacitance generated by the first transistor. To overcome this, cross-coupled dummy transistors connected to the sampling circuit are used. When dummy transistors connected to the sampling circuit are used, the high-frequency signal may be offset by transmitting a signal with a phase difference of 180 degrees in the hold state. However, the dummy transistors connected to the sampling circuit have a problem of generating additional parasitic capacitance caused by drain-to-body (CDB) or source-to-body (CSB), thereby adversely affecting high-speed operation and reducing the operation speed of the circuit. In addition, signal attenuation may occur due to a leakage path by the dummy transistor at high temperatures. To overcome this, when the capacitance corresponding to CDS2 is implemented as a simple metal capacitor, mismatch between CDS1 and CDS2 occurs due to the process, resulting in a difference from CDS1 and reducing the high-frequency signal offset effect.

According to one or more embodiments, while the patterns of the FEOL and BEOL remain the same, CDS2 made of BEOL may be implemented by removing the contact connecting the FEOL with the BEOL. In this case, the gate pattern is connected to the clock signal CKS to equalize the output impedance of the input transistor, that is, the clock buffer seen from the gate of the first transistor, thereby maximizing the high-frequency signal offset effect. The sample and hold circuit according to one or more embodiments may reduce a clock feed-through due to the use of the dummy metal. In addition, the parasitic capacitance of the first transistor is less than the parasitic capacitance of the dummy transistor, and the parasitic resistance of the first transistor is less than the parasitic resistance of the dummy transistor, thereby being advantageous in a high-speed operation. There is an advantage that there is no resistance component between the differential inputs by the dummy transistor. In addition, one or more embodiments according to the disclosure may have characteristics robust to process variation due to the use of the same pattern as the input transistor compared to a general capacitor.

FIG. 7 is a diagram illustrating layout arrangement of transistors included in a sample and hold circuit according to one or more embodiments. FIG. 7 is a layout view for describing an integrated circuit 220 including a sample and hold circuit according to one or more embodiments. In detail, FIG. 7 is a layout view for explaining metal patterns of a first metal layer M1 of the integrated circuit 220.

FIG. 7 is a plan view showing a part of the integrated circuit 220 constituting one chip or one functional block in a plane consisting of an X-axis and a Y-axis. In the present specification, the X-axis direction and the Y-axis direction may be referred to as a first horizontal direction and a second horizontal direction, respectively, and the Z-axis direction may be referred to as a vertical direction. A plane consisting of X and Y axes may be referred to as a horizontal plane, a component arranged in the +Z axis direction relative to another component may be referred to as being above another component, and a component arranged in the -Z axis direction relative to another component may be referred to as being below another component.

The integrated circuit 220 may include a plurality of standard cells. A standard cell is a unit of a layout included in the integrated circuit and may be designed to perform a predefined function, or may be referred to as a cell. The integrated circuit 220 may include a number of various standard cells, and the standard cells may be aligned and arranged according to a plurality of rows.

The plurality of standard cells are repeatedly used in a design of an integrated circuit. The standard cells may be pre-designed according to a manufacturing technique and stored in a standard cell library, and the standard cells stored in the standard cell library may be arranged and interconnected according to a design rule, thereby designing an integrated circuit.

The standard cells may include logic cells. For example, logic cells may implement circuits that make up various basic circuits that are often used in a digital circuit design for electronic devices such as central processing units (CPUs), graphics processing units (GPUs), and system-on-chips (SOCs), together with inverters, AND gates, NAND gates, OR gates, XOR gates, and NOR gates. Alternatively, for example, logic cells may implement other circuits that are often used in circuit blocks, such as flip-flops and latches. According to one or more embodiments, each of the logic cells may include a sample and hold circuit.

Each of the standard cells may include a filler cell. The filler cell is arranged adjacent to a functional cell, thereby providing routing of signals provided to the functional cell or output from the functional cell. In addition, the filler cells may be cells used to fill the remaining space after the functional cells are placed.

The integrated circuit 220 may include metal layers on which wirings for interconnecting the standard cells are formed. Some of the metal layers may be used as a configuration for interconnecting elements inside the standard cells.

The plurality of metal layers may be sequentially stacked in a vertical direction, for example, a second metal layer may be formed on a first metal layer M1, and a third metal layer may be formed on the second metal layer. In one or more embodiments, the first metal layer M1 may include patterns extending in the X-axis direction, the second metal layer may include patterns extending in the Y-axis direction, and the third metal layer may include patterns extending in the X-axis direction. In addition, other metal layers may be further formed on the third metal layer.

The patterns formed on each of the metal layers may be formed of metal, conductive metal nitride, metal silicide, or a combination thereof. In the drawings of this specification, only some layers may be illustrated for convenience of illustration, and vias may be displayed even though vias are located under the pattern of the metal layers to indicate the connection between the upper pattern and the lower pattern of the metal layer.

The integrated circuit 220 according to one or more embodiments may include a transistor region cell TR_1 and a dummy transistor region cell DTR_1. According to one or more embodiments, the transistor region cell TR_1 may be a region in which logic cells including the first transistor and the second transistor of the sampling circuit are arranged. According to one or more embodiments, the dummy transistor region cell DTR_1 may be a region in which logic cells including the first dummy transistor and the second dummy transistor of the sampling circuit are arranged. The transistor region cell TR_1 and the dummy transistor region cell DTR_1 may be arranged adjacent to each other in the X-axis direction. Transistor region cells TR_1 and dummy transistor region cells DTR_1 may be arranged adjacent to each other in the Y-axis direction.

According to one or more embodiments, the transistor region cell TR_1 may include a metal pattern including a plurality of metal lines P1, P2, P3, P4, and P5 that supply a voltage to each of logic cells corresponding to the transistor region cell TR_1. According to one or more embodiments, the dummy transistor region cell DTR_1 may include a pattern including a plurality of metal lines P1', P2', P3', P4', and P5' that supply a voltage to each of logic cells corresponding to the dummy transistor region cell DTR_1. According to one or more embodiments, the plurality of metal lines included in the transistor region cell TR_1 and the dummy transistor region cell DTR_1 may be arranged to extend in the X-axis direction and may be spaced apart from each other in the Y-axis direction. According to one or more embodiments, when the transistor region cell TR_1 and the dummy transistor region cell DTR_1 are arranged adjacent to each other in the Y-axis direction, the plurality of metal lines included in the transistor region cell TR_1 and the dummy transistor region cell DTR_1 are arranged to extend in the Y-axis direction and may be spaced apart from each other in the X-axis direction. According to one or more embodiments, the transistor region cell TR_1 and the dummy transistor region cell DTR_1 adjacent to the transistor region cell TR_1 may include the same pattern. In the present disclosure, the meaning of including the same pattern may mean including the same transistors and the same metal lines.

According to one or more embodiments, each of the plurality of metal lines P1, P2, P3, P4, and P5 included in the transistor area cell TR_1 may include vias V1, V2, V3, V4, and V5 electrically connectable to a plurality of transistors included in the transistor area cell TR_1. The vias V1, V2, V3, V4, and V5 included in the transistor region cell TR_1 may extend in the Z-axis direction. Each of a plurality of metal lines P1', P2', P3', P4', and P5' included in the dummy transistor region cell DTR_1 having the same pattern as the transistor region cell TR_1 may not include a via.

The plurality of metal lines P1, P2, P3, P4, and P5 included in the first metal layer included in the transistor region cell TR_1 may be electrically connected to an upper layer of the first metal layer, for example, a second metal layer, and may be electrically connected to a device formed under the first metal layer M1, for example, a transistor. The plurality of metal lines P1', P2', P3', P4', and P5' included in the first metal layer included in the dummy transistor region cell DTR_1 may be electrically connected to an upper layer of the first metal layer, for example, a second metal layer, and may not be electrically connected to a device formed under the first metal layer, for example, a dummy transistor.

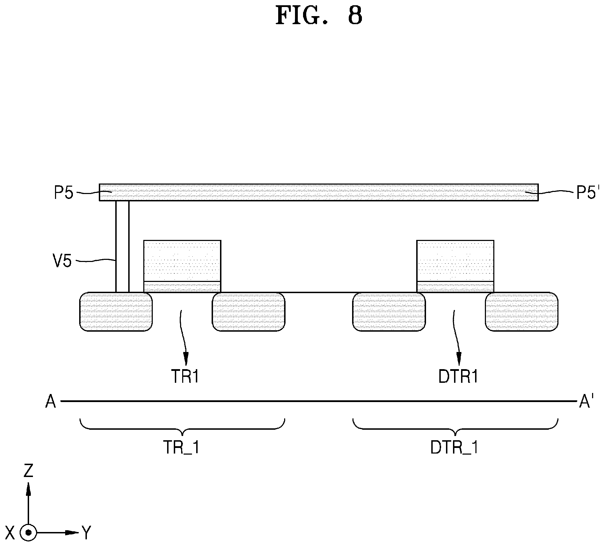

FIG. 8 is a cross-sectional view of the layout diagram of FIG. 7 taken along line A-A'.

Referring to FIG. 8, provided are the first metal line P5 included in the transistor region cell TR_1, the first transistor TR1 arranged below the first metal line P5, and the via V5 extending in a Z-axis direction so as to connect the first metal line P5 with a drain region of the first transistor TR1 in the Z-axis direction. In addition, the dummy transistor region cell DTR_1 is provided with the second metal line P5' and the first dummy transistor DTR1 arranged under the second metal line P5', and it may be confirmed that there is no via connecting the second metal line P5' with the first dummy transistor DTR1 in the dummy transistor region cell DTR_1. The first metal line P5 and the second metal line P5' may be electrically connected to each other.

Referring to FIG. 8, the dummy transistor region cell DTR_1 and the transistor region cell TR_1 may be connected through metal lines P5 and P5' arranged at the same layer, and the dummy transistor DTR1 included in the dummy transistor region cell DTR_1 may not be connected to the metal line P5' included in the dummy transistor region cell DTR_1.

According to one or more embodiments, a via connecting the FEOL region with the BEOL region is removed from the dummy transistor region cell DTR_1, and a signal line of each of the gate terminal, the source terminal, and the drain terminal of the dummy transistor DTR1 included in the dummy transistor region cell DTR_1 is connected in the same manner to a signal line of each of the gate terminal, the source terminal, and the drain terminal of the transistor TR1 included in the transistor region cell TR_1 so that the same load is applied as much as possible. That is, the signal connection structure of the dummy transistor of the dummy transistor region cell DTR_1 may be the same as the signal connection structure of the transistor of the standard cell adjacent thereto, that is, the transistor region cell TR_1.

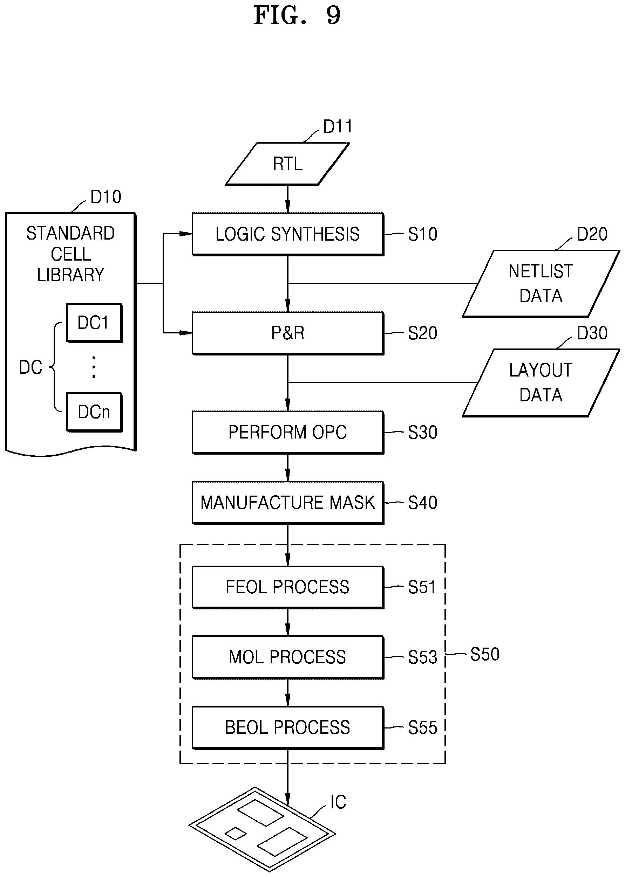

FIG. 9 is a flowchart illustrating a method of manufacturing an integrated circuit, according to one or more embodiments.

Referring to FIG. 9, a standard cell library D10 may include information about standard cells, for example, function information, characteristic information, layout information, and the like. The standard cell library D10 may include data DC defining a layout of each of the standard cells. The data DC may include data that defines structures of standard cells that perform the same functions and have different layouts. The data DC may include data defining the structures of the standard cells. The data DC may include first data DC1 that defines a structure of standard cells that perform a first function and have different layouts, and n-th data DCn, where n is a natural number of 2 or more that defines a structure of standard cells that perform an n-th function and have different layouts.

Operations S10 and S20 may generate layout data D30 from RTL data D11 as operations of designing an integrated circuit IC. The integrated circuit IC may be at least one of the integrated circuits of FIGS. 7 and 8. In operation S10, a logic synthesis operation of generating netlist data D20 from the RTL data D11 may be performed. For example, a semiconductor design tool (e.g., a logic synthesis module) may generate netlist data D20 including a bitstream or a netlist by performing a logical synthesis with reference to the standard cell library D10 from RTL data D11 created as a hardware description language (HDL) such as VHSIC Hardware Description Language (VHDL) and Verilog. The standard cell library D10 may contain data DC that defines the structure of standard cells that perform the same function and have different layouts, and standard cells may be included in the integrated circuit IC by referring to such information in the logical synthesis process.

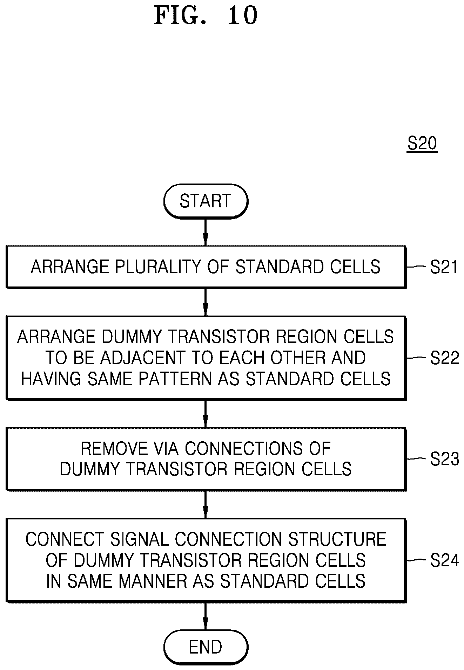

In operation S20, a place and routing (P&R) operation of generating layout data D30 from the netlist data D20 may be performed. The layout data D30 may have, for example, a format such as GDSII and may include geometric information of standard cells and interconnections. In one or more embodiments, operation S20 may include operations S21 to S24 of FIG. 10.

In operation S20, the semiconductor design tool (e.g., the P&R module) may place the plurality of standard cells by referring to the standard cell library D10 from the netlist data D20. The semiconductor design tool such as the P&R module may select one of the layouts of the standard cells defined by the netlist D20 by referring to data DC, and may arrange the selected layout of the standard cells.

In addition, in operation S20, the semiconductor design tool may perform a routing operation, which is an operation of creating interconnections. "Routing" may be an operation of placing wiring layers and vias required to properly connect the placed standard cells according to design rules for integrated circuits. The interconnection may electrically connect the output pin and the input pin of the standard cell to another cell, and may include, for example, at least one via and a conductive pattern formed on the at least one metal layer. Patterns formed on metal layers of different levels may be electrically connected to each other through vias made of conductive materials. In this case, the metal layers may include metals as a conductive material.

In operation S30, an optical proximity correction (OPC) may be performed. The OPC may refer to an operation of forming a pattern of a desired shape by correcting distortion such as refraction due to the characteristics of light in photolithography included in a semiconductor process for manufacturing integrated circuits, and a pattern may be determined on a mask by applying the OPC to the layout data D30. In one or more embodiments, the layout of the integrated circuit (IC) may be limitedly modified in operation S30, and the limited modification of the integrated circuit (IC) in operation S30 may be referred to as design polishing as post-processing for optimizing the structure of the integrated circuit (IC).

In operation S40, an operation of manufacturing a mask may be performed. For example, patterns on a mask may be defined to form patterns formed on a plurality of layers by applying the OPC to the layout data D30, and at least one mask (or a photomask) for forming patterns of each of the plurality of layers may be manufactured.

In operation S50, an operation of fabricating the integrated circuit IC may be performed. For example, an integrated circuit IC may be manufactured by patterning a plurality of layers using at least one mask manufactured in operation S40. Operation S50 may include operations S51, S53, and S55 and may include a deposition process, an etching process, an ion process, a cleaning process, and the like. In addition, operation S50 may include a packaging process of mounting a semiconductor device on a printed circuit board (PCB) and sealing the mounted semiconductor device with a sealing material, or a test process of testing a semiconductor device or package.

In operation S51, an FEOL process may be performed. The FEOL process may refer to a process of forming individual elements, for example, a transistor, a capacitor, a resistor, etc., on a substrate in a process of manufacturing an integrated circuit (IC). For example, the FEOL process may include planarizing and cleaning a wafer, forming a trench, forming a well, forming a gate line, forming a source region and a drain region, and the like.

In operation S53, a middle-of-line (MOL) process may be performed. The MOL process may refer to a process of forming a connection member for connecting individual devices generated through the FEOL process within standard cells. For example, the MOL process may include forming an active contact on an active region, forming a gate contact on a gate line, forming vias on an active contact and a gate line, and the like.

In operation S55, a BEOL process may be performed. The BEOL process may refer to a process of interconnecting individual elements, e.g., transistors, capacitors, resistors, etc., during the fabrication of an integrated circuit (IC). For example, the BEOL process may include silicidizing gates, sources and drain regions, adding a dielectric, planarizing, forming holes, forming metal layers, forming vias between the metal layers, forming passivation layers, and the like. An integrated circuit (IC) may then be packaged in a semiconductor package and used as a component of various applications.

FIG. 10 is a flowchart illustrating a method of manufacturing an integrated circuit, according to one or more embodiments.

Operations S21 to S24 according to FIG. 10 may be included in operation S20 of FIG. 9.

Referring to operation S21, a plurality of standard cells may be arranged. Each of the plurality of standard cells may include logic cells, and according to one or more embodiments, each of the logic cells may include a sample and hold circuit.

Referring to operation S22, dummy transistor region cells having the same pattern as the standard cells may be arranged adjacent to each other. According to one embodiment, the standard cells may include transistor region cells corresponding to the sampling circuit, and dummy transistor region cells may be placed adjacent to the X-axis direction or Y-axis direction of the transistor region cells. In this case, the dummy transistor region cells may be arranged in the same pattern as the transistor region cells. According to one or more embodiments, the dummy transistors included in the dummy transistor region cells and the transistors included in the transistor region cells may have the same volume in size.

Referring to operation S23, the via connection of the dummy transistor region cells may be removed. According to one or more embodiments, vias connecting the dummy transistors of the FEOL region included in the dummy transistor region cell and a metal line arranged in the lowermost layer of the BEOL region included in the dummy transistor region cell may be removed. Accordingly, only the dummy metal line may be connected to the sampling circuit.

Referring to operation S24, a signal connection structure of the dummy transistor region cell may be connected in the same manner as the standard cells. According to one or more embodiments, signals connected to a gate terminal, a source terminal, and a drain terminal of each of the dummy transistors included in a dummy transistor region cell may be connected to be the same as signals connected to a gate terminal, a source terminal, and a drain terminal of each of the transistors included in the transistor region cells. Accordingly, the same clock signal as the clock signal applied to input transistor is applied to the gate pattern to minimize the influence of feed-through.

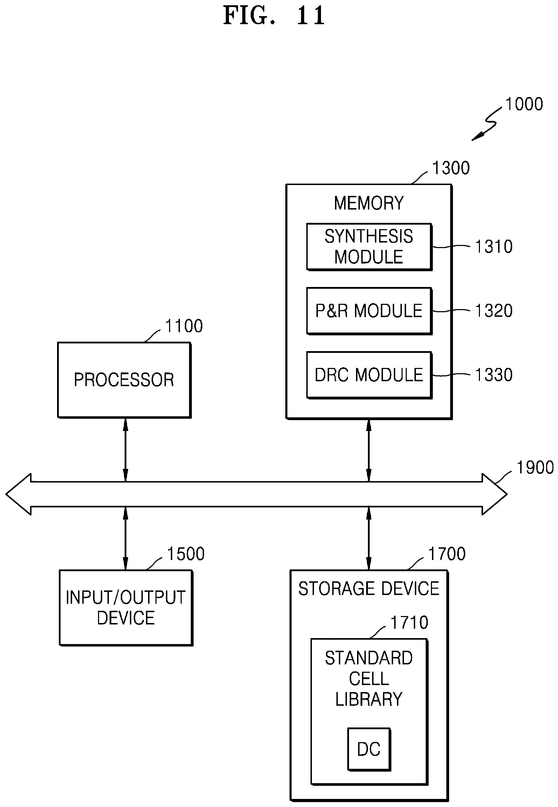

FIG. 11 is a block diagram illustrating a computing system for designing an integrated circuit according to one or more embodiments.

Referring to FIG. 11, a computing system (hereinafter, referred to as an integrated circuit design system) 1000 for designing an integrated circuit may include a processor 1100, a memory 1300, an input/output device 1500, a storage device 1700, and a bus 1900.

The integrated circuit design system 1000 may perform an integrated circuit design operation including operations S10 and S20 of FIG. 9, and an integrated circuit design operation including operations S21 to S24 of FIG. 10. In one or more embodiments, the integrated circuit design system 1000 may be implemented as an integrated device and may thus be referred to as an integrated circuit design apparatus. The integrated circuit design system 1000 may be provided as a dedicated device for designing an integrated circuit of a semiconductor device, but may be a computer for driving various simulation tools or design tools. The integrated circuit design system 1000 may be a fixed computing system, such as a desktop computer, a workstation, a server, etc., and may be a portable computing system, such as a laptop computer.

The processor 1100 may be configured to execute instructions for performing at least one of various operations for designing an integrated circuit. For example, the processor 1100 may include a core capable of executing any instruction set (e.g., Intel Architecture-32 (IA32), 64-bit extended IA-32, x86-64, PowerPC, Sparc, MIPS, ARM, IA-64, etc.), such as a micro-processor an application processor (AP), a digital signal processor (DSP), or a GPU. The processor 1100 may communicate with the memory 1300, the input/output device 1500, and the storage device 1700 through the bus 1900. The processor 1100 may execute a design operation of an integrated circuit by driving a synthesis module 1310, a P&R module 1320, and a design rule check (DRC) module 1330, which are loaded in the memory 1300.

The memory 1300 may store the synthesis module 1310, the P&R module 1320, and the DRC module 1330. The synthesis module 1310, the P&R module 1320, and the DRC module 1330 may be loaded from the storage device 1700 to the memory 1300. The synthesis module 1310 may be, for example, a program that includes a plurality of instructions for performing a logic synthesis operation according to operation S10 of FIG. 9.

The P&R module 1320 may be, for example, a program that includes a plurality of instructions for performing a layout design operation according to operation S20 of FIG. 9. According to one or more embodiments, the P&R module 1320 may secure high-speed operations of the sampling circuit by placing the transistor region and the dummy transistor region to be adjacent to each other when designing the layout of the sampling circuit and removing vias in the dummy transistor region.

The DRC module 1330 may determine whether a design rule error exists. The DRC module 1330 may be a program including a plurality of instructions for performing the DRC operation including a design rule verification operation. When there is a violation against the design rule, the P&R module 1320 may adjust the layout of the arranged cells. When there is no design rule error, the layout design of the integrated circuit may be completed.

The memory 1300 may be a volatile memory, such as static random access memory (SRAM) or dynamic RAM (DRAM), or a non-volatile memory, such as phase change RAM (PRAM), resistive RAM (ReRAM), nano floating gate memory (NFGM), polymer RAM (PoRAM), magnetic RAM (MRAM), ferroelectric RAM (FRAM), flash memory, or the like.

The input/output device 1500 may control user input and output from user interface devices. For example, the input/output device 1500 is provided with input devices such as keyboards, mouses, and touch pads, and may receive input data and the like defining integrated circuits. For example, the input/output device 1500 may be provided with an output device such as a display, a speaker, and the like, to display arrangement results, routing results, layout data, DRC results, etc.

The storage device 1700 may store programs such as the synthesis module 1310, the P&R module 1320, and the DRC module 1330, and the program or at least a part thereof may be loaded from the storage device 1700 to the memory 1300 before the program is executed by the processor 1100. The storage device 1700 may also store data to be processed by the processor 1100 or data processed by the processor 1100. For example, the storage device 1700 may store data (for example, a standard cell library 1710 and netlist data) to be processed by programs such as the synthesis module 1310, the P&R module 1320, and the DRC module 1330 and data (for example, DRC result data, layout data, etc.) generated by programs. The standard cell library 1710 stored in the storage device 1700 may be the standard cell library D10 of FIG. 9.

For example, the storage device 1700 may include a nonvolatile memory such as electrically erasable programmable read-only memory (EEPROM), flash memory, PRAM, RRAM, MRAM, and FRAM, or a storage medium such as a memory card (MMC, eMMC, SD, MicroSD, etc.), a solid state drive (SSD), a hard disk drive (HDD), magnetic tape, an optical disk, and a magnetic disk. In addition, the storage device 1700 may be detachable from the integrated circuit design system 1000.

While certain embodiments of the disclosure has been particularly shown and described, it will be understood that various changes in form and details may be made therein without departing from the scope of the following claims.

### Annex A

The present invention can also be defined by reference to the following clauses:
Clause 1. An integrated circuit comprising:
   a transistor region cell comprising a pattern corresponding to a plurality of transistors in a sample and hold circuit; and
   a dummy transistor region cell comprising the pattern of the transistor region cell,
   wherein the dummy transistor region cell and the transistor region cell are connected by metal lines provided in a same layer, and
   wherein dummy transistors in the dummy transistor region cell are not connected to the metal lines.
Clause 2. The integrated circuit of clause 1, wherein the transistor region cell and the dummy transistor region cell are provided adjacent to each other in an X-axis direction or a Y-axis direction.

## Claims

1. A sample and hold circuit comprising:
a first transistor connected between a first input terminal configured to receive a first input signal and a first output terminal configured to output a first sampled signal;
a second transistor connected between a second input terminal configured to receive a second input signal and a second output terminal configured to output a second sampled signal;
a first dummy transistor provided between the first input terminal and the second output terminal; and
a second dummy transistor provided between the second input terminal and the first output terminal,
wherein a source region and a drain region of the first dummy transistor and a source region and a drain region of the second dummy transistor are not electrically connected to a metal line connecting the first transistor with the second transistor.

2. The sample and hold circuit of claim 1, wherein the first input signal and the second input signal are a differential signal pair.

3. The sample and hold circuit of any preceding claim, wherein each of the first input signal and the second input signal is a high-speed analog signal.

4. The sample and hold circuit of claim 3, wherein each of the first input signal and the second input signal has a speed of gigahertz or higher.

5. The sample and hold circuit of any preceding claim, wherein the first dummy transistor, the second dummy transistor, the first transistor, and the second transistor are a same size.

6. The sample and hold circuit of any preceding claim, wherein a gate of the first dummy transistor and a gate of the first transistor are connected to a first signal line, and a gate of the second dummy transistor and a gate of the second transistor are connected to a second signal line.

7. The sample and hold circuit of any preceding claim, further comprising:
a first capacitor connected between the first transistor and the first output terminal; and
a second capacitor connected between the second transistor and the second output terminal.

8. A method of manufacturing an integrated circuit comprising a metal layer, the method comprising:
providing a plurality of standard cells, each of the plurality of standard cells comprising metal patterns in the metal layer;
providing a plurality of dummy transistor region cells adjacent to each other and having the metal patterns of the plurality of standard cells; and
removing via connections in the plurality of dummy transistor region cells.

9. The method of manufacturing an integrated circuit of claim 8, wherein the providing the plurality of standard cells comprises providing a plurality of transistor region cells comprising a plurality of transistors corresponding to a sample and hold circuit.

10. The method of manufacturing an integrated circuit of claim 9, wherein a gate of a dummy transistor in each of the plurality of dummy transistor region cells and a gate of a transistor in each of the plurality of transistor region cells are connected to a same signal line.

11. The method of manufacturing an integrated circuit of claim 9 or claim 10, wherein the providing the plurality of dummy transistor region cells comprises providing the plurality of transistor region cells adjacent to each other in an X-axis direction or a Y-axis direction.

12. The method of manufacturing an integrated circuit of claim 11, wherein the removing of the via connections in the plurality of dummy transistor region cells comprises removing vias connecting the metal patterns with dummy transistors in a Z-axis direction.

13. The method of manufacturing an integrated circuit of any of claims 8 to 12, further comprising:
connecting a signal connection structure of the plurality of dummy transistor region cells in a same manner as the plurality of standard cells.

14. An integrated circuit as claimed in any of claims 1 to 7, the integrated circuit comprising:
a transistor region cell comprising a pattern corresponding to a plurality of transistors in the sample and hold circuit, the plurality of transistors comprising the first transistor and the second transistor; and
a dummy transistor region cell comprising the pattern of the transistor region cell,
wherein the dummy transistor region cell and the transistor region cell are connected by metal lines provided in a same layer, and
wherein dummy transistors in the dummy transistor region cell are not connected to the metal lines, the dummy transistors including the first dummy transistor and the second dummy transistor.

15. The integrated circuit of claim 14, wherein the transistor region cell and the dummy transistor region cell are provided adjacent to each other in an X-axis direction or a Y-axis direction.
